**Europäisches Patentamt**

**European Patent Office**

**Office européen des brevets**

(11) Veröffentlichungsnummer: **0 114 180**
**B1**

(19)

(12) # EUROPÄISCHE PATENTSCHRIFT

(45) Veröffentlichungstag der Patentschrift:
**24.05.89**

(51) Int. Cl.⁴: **H 03 H 5/02**

(21) Anmeldenummer: **83107128.7**

(22) Anmeldetag: **21.07.83**

(54) Hochfrequenzresonanzkreis.

(30) Priorität: **23.12.82 DE 3247662**

(43) Veröffentlichungstag der Anmeldung:
**01.08.84 Patentblatt 84/31**

(45) Bekanntmachung des Hinweises auf die Patenterteilung:
**24.05.89 Patentblatt 89/21**

(84) Benannte Vertragsstaaten:
**FR GB NL**

(56) Entgegenhaltungen:
**DE-U- 7 112 114**
**FR-A- 976 775**
**US-A- 1 921 448**

(73) Patentinhaber: **ROBERT BOSCH GMBH, Postfach 50,
D-7000 Stuttgart 1 (DE)**

(72) Erfinder: **Franke, Manfred, Stubenrauchstrasse 53,
D-1000 Berlin 41 (DE)**
Erfinder: **Scholtz, Klaus, Säntisstrasse 60,
D-1000 Berlin 48 (DE)**

(74) Vertreter: **Schmidt, Hans-Ekhardt, Robert Bosch GmbH
Geschäftsbereich Elektronik Patent- und
Lizenzabteilung Forckenbeckstrasse 9-13,
D-1000 Berlin 33 (DE)**

## Beschreibung

Stand der Technik

Die Erfindung geht von einem Hochfrequenzresonanzkreis nach der Gattung des Anspruchs 1 aus. Ein solcher Hochfrequenzresonanzkreis ist aus der DE-U-7 112 114 bekannt.

Es sind Hochfrequenzresonanzkreise in verschiedenen Ausführungsformen bekannt, die zum Beispiel eine hohe Güte bei verhältnismäßig kleinen Abmessungen aufweisen. Derartige Resonanzkreise verändern jedoch erfahrungsgemäß ihre Resonanzfrequenz, wenn sich ändernde parasitäre Kapazitäten auftreten. Bei in Fahrzeugen eingebauten Funkgeräten ergeben sich beispielsweise Kapazitätsänderungen durch nichtvermeidbare mechanische Schwingungen des Fahrzeuges. Abhilfe können hier nur niederohmige Resonatoren schaffen, die jedoch mit handelsüblichen Bauteilen nicht realisierbar sind, oder Topfkreise, die verhältnismäßig viel Platz beanspruchen.

Vorteile der Erfindung

Der erfindungsgemäße Hochfrequenzresonanzkreis mit den kennzeichnenden Merkmalen des Anspruchs 1 hat den Vorteil, daß durch einen besonders kompakten Aufbau eine verhältnismäßig große Resonanzkreiskapazität (30 ... 50 pF) bei einer Kreisgüte von mindestens 250 erzielt werden kann. Dadurch ist der Resonanzkreis gegenüber parasitären Kapazitäten weitgehend unempfindlich. Auf diese Weise lassen sich auch die Rauscheigenschaften von mit PLL(Phase-locked loop)-Oszillatoren ausgerüsteten Funkgeräten verbessern. Da die Regelgeschwindigkeit der Phasenschleife eines PLL-Oszillators – bedingt durch das Kanalraster – verhältnismäßig klein ist, wird das Phasenrauschen des frei schwingenden spannungsgesteuerten Oszillators (VCO) durch die Regelschleife nicht verbessert. Es sind zwar Schaltungen bekannt, bei denen dieser Nachteil durch Anwendung von mindestens zwei Regelschleifen unterschiedlicher Regelgeschwindigkeit vermieden wird. Diese Schaltungen sind jedoch verhältnismäßig aufwendig. Der erfindungsgemäße Hochfrequenzresonankreis führt trotz seiner Einfachheit zu einer erheblichen Verringerung der Rauschwerte des spannungsgesteuerten Oszillators.

Durch die in den Unteransprüchen aufgeführten Maßnahmen sind vorteilhafte Weiterbildungen und Verbesserungen des im Anspruch 1 angegebenen Hochfrequenzresonanzkreises möglich. Besonders vorteilhaft ist ein erfindungsgemäßer Hochfrequenzresonanzkreis, bei dem jeder Plattenkondensator ein hochisolierendes Plättchen mit beidseitig vorhandenen Kondensatorbelägen aufweist, bei dem das eine Ende der Spule zwischen den einander zugekehrten Kondensatorbelägen hindurchgeführt ist und bei dem die beiden außenliegenden Kondensatorbeläge von einer Klammer aus einem leitenden Werkstoff umschlossen sind. Der Hochfrequenzresonanzkreis läßt sich mit einem verhältnismäßig hohen Kapazitätswert auf einfache Weise herstellen.

Zeichnung

Zwei Ausführungsbeispiele der Erfindung sind in der Zeichnung an Hand mehrerer Figuren dargestellt und in der nachfolgenden Beschreibung näher erläutert. Die Zeichnung zeigt in

Fig. 1 einen horizontalen Schnitt durch einen erfindungsgemäßen Hochfrequenzresonanzkreis in einer ersten, in vergrößertem Maßstab dargestellten Ausführungsform,

Fig. 2 eine stark vergrößerte Seitenansicht eines erfindungsgemäßen Doppel-Plattenkondensators für den Resonanzkreis gemäß Fig. 1 im Schnitt,

Fig. 3 einen vertikalen Schnitt durch einen Resonanzkreis gemäß Fig. 1,

Fig. 4 ein Ersatzschaltbild eines Resonanzkreises gemäß Fig. 1 bis 3,

Fig. 5 einen stark vergrößerten Ausschnitt aus einem erfindungsgemäßen Hochfrequenzresonanzkreis in einer zweiten Ausführungsform,

Fig. 6 eine Seitenansicht eines erfindungsgemäßen Plattenkondensators für einen Resonanzkreis gemäß Fig. 5,

Fig. 7 ein Ersatzschaltbild eines Resonanzkreises gemäß Fig. 5 und 6,

Fig. 8 eine Schnittansicht eines Abschirmtopfes, dessen offene Seite durch eine Leiterfläche abgeschlossen ist,

Fig. 9 einen horizontalen Schnitt durch einen erfindungsgemäßen Resonanzkreis in einer dritten Ausführungsform,

Fig. 10 einen Längsschnitt eines Resonanzkreises gemäß Fig. 9,

Fig. 11 eine Seitenansicht einer kunststoffumhüllten Spule und

Fig. 12 einen Ausschnitt einer Draufsicht der kunststoffumhüllten Spule gemäß Fig. 11 in vergrößertem Maßstab.

Beschreibung der Erfindung

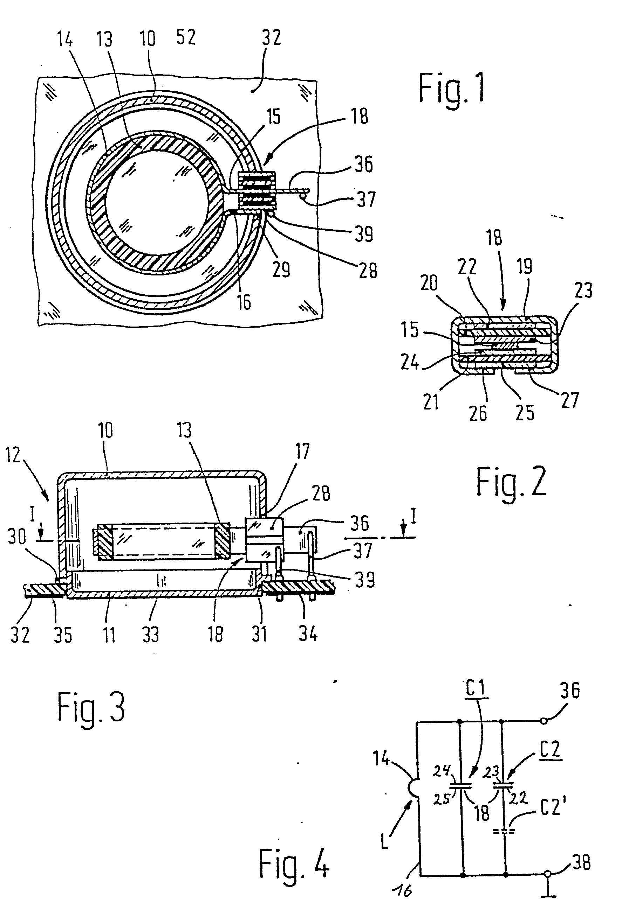

In den Fig. 1 und 3, die einen erfindungsgemäßen Hochfrequenzresonanzkreis in einer ersten Ausführungsform zeigen, bedeuten 10 ein Oberteil und 11 ein Bodenteil eines hochfrequenzdicht abgeschlossenen zylindrischen Abschirmtopfes 12. In dem Oberteil befindet sich ein Spulenkörper in Form einer Isolierstoffrolle 13, zum Beispiel aus Keramik, die eine Spule 14 mit einer fast geschlossenen Windung aus einem elektrisch gut leitenden Band, zum Beispiel einem versilberten Kupferband oder einem Reinsilberband, trägt. Die Bandenden 15 und 16 weisen in derselben Richtung radial nach außen und haben einen geringen Abstand voneinander.

Das Oberteil 10 enthält einen radialen Schlitz 17, in den ein Doppel-Plattenkondensator 18 paßt, der etwas aus dem Abschirmtopf 12 herausragt und einen insbesondere aus Fig. 2 zu ersehenden Aufbau hat.

Eine U-förmige Klammer 19 aus leitendem Material nimmt zwei hochisolierende Plättchen 20 und 21, zum Beispiel aus Glimmer oder einer titanisierten Keramik, auf, die beidseitig mit je einem Kondensatorbelag 22 und 23 bzw. 24 und 25 versehen sind. Zwischen den innen liegenden Kondensatorbelägen 23 und 24 ist das Bandende 15 der Spule 14 hindurchgeführt. Die Plättchen 20 und 21 mit ihren Kondensatorbelägen sowie das Bandende 15 werden nach dem Einwärtsbiegen von Schenkelenden 26 und 27 der Klammer 19 zusammengehalten. Zwischen der Außenseite 28 des in den Schlitz 17 des Abschirmtopfes 12 eingesetzten Doppel-Plattenkondensators 18 und der dieser Außenseite benachbarten Seite 29 des Schlitzes 17 liegt das andere Bandende 16. Die Klammer 19 und das Bandende 16 sind gemeinsam in dem Schlitz 17, vorzugsweise durch Löten, befestigt und somit leitend mit dem Abschirmtopf verbunden.

Das mit dem Oberteil 10 vorzugsweise durch Löten verbundene Bodenteil 11 weist einen ringförmigen Flansch 30 auf, mit dem sich der Abschirmtopf 12 bei in eine Öffnung 31 einer Leiterplatte 32 gestecktem Bodenteil 11 abstützt. Im eingesteckten Zustand des Abschirmtopfes schließt die Unterseite 33 des Bodenteils bündig mit der Ebene der Leiterplatte 32 bzw. der darauf angebrachten Leitungsbahnen 34, 35 ab.

Das aus dem Doppel-Plattenkondensator 18 herausragende freie Bandende 36 ist mit einem ersten Anschlußstift 37 elektrisch leitend verbunden, der in der Leiterplatte 32 befestigt ist und mit einer der Leiterbahnen 34, 35 elektrisch leitend verbunden ist. Mit einer Fläche 28 des Doppel-Plattenkondensators 18 ist ein zweiter Anschlußstift 39 elektrisch leitend verbunden, der ebenfalls in der Leiterplatte 32 befestigt ist und mit einer auf dem Massepotential liegenden Leiterbahn der Leiterplatte elektrisch verbunden ist.

Die Wirkungsweise des vorstehend beschriebenen Hochfrequenzresonanzkreises ist folgende:

Die Spule 14 bildet eine Induktivität L (vgl. Ersatzschaltbild in Fig. 4) und je ein Paar der durch ein hochisolierendes Plättchen 21 und 22 voneinander getrennten Kondensatorbeläge 22 und 23 bzw. 24 und 25 je eine Kapazität C1, C2. Die Kapazitäten C1 und C2 sind parallelgeschaltet, so daß sich ihre Kapazitätswerte addieren, während sich ihre unerwünschten Induktivitätswerte halbieren.

Je nach der gewünschten Resonanzfrequenz des Hochfrequenzresonanzkreises können anstelle der in Fig. 1 gezeigten fast vollständigen Windung auch Teile einer Windung oder gegebenenfalls mehr als eine Windung – bis zu maximal zwei Windungen – vorgesehen werden, wobei eine entsprechend anders geformte Isolierstoffrolle 13 benötigt wird, auf der das leitende Band zum Beispiel schraubenlinienförmig aufzubringen wäre.

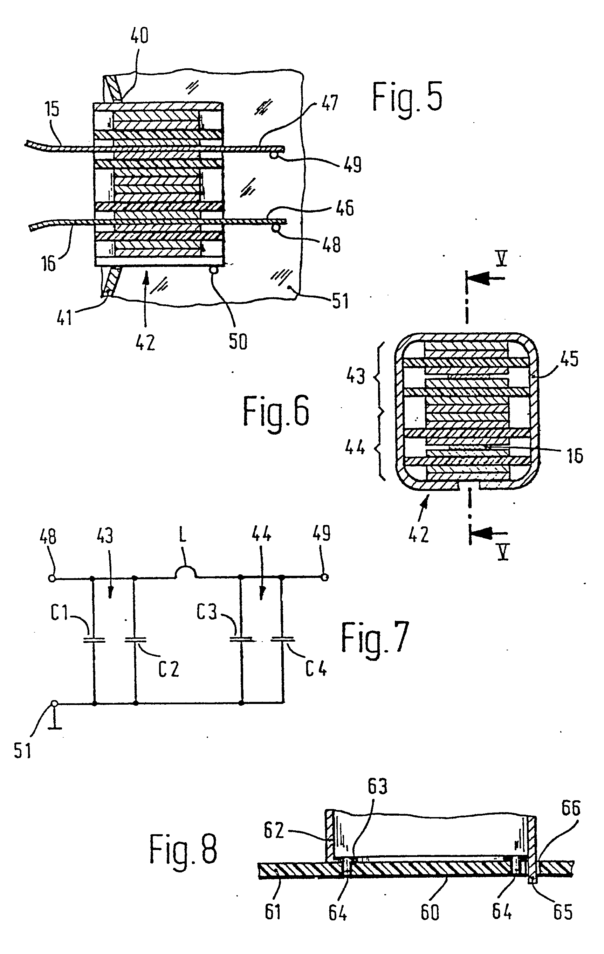

In einer zweiten Ausführungsform eines erfindungsgemäßen Hochfrequenzresonanzkreises ist in einer Öffnung 40 eines zylindrischen Abschirmtopfes 41 ein Vierfachkondensator 42 (Fig. 5 und 6) vorgesehen, der aus zwei Doppel-Plattenkondensatoren 43 und 44 besteht. Die beiden Plattenkondensatoren sind durch eine zusätzliche, elektrisch leitende Klammer 45 (Fig. 6) zusammengehalten. In diesem Fall ist das Bandende 16 gemäß Fig. 1 so weit verlängert, daß es durch den Doppel-Plattenkondensator 44 nach außen geführt werden kann und ein freies Bandende 46 bildet. Das freie Bandende 46 und das dem Bandende 15 in Fig. 1 entsprechende freie Bandende 47 sind mit je einem Anschlußstift 48, 49 verbunden, der ebenso wie ein mit der Klammer 45 leitend verbundener Anschlußstift 50 in einer Leiterplatte 51 befestigt ist.

Das Ersatzschaltbild (Fig. 7) eines derartigen Resonanzkreises zeigt, daß die Doppel-Plattenkondensatoren 43, 44 je zwei parallelgeschaltete Kapazitäten C1, C2 bzw. C3, C4 aufweisen. Die zuletzt beschriebene Ausführungsform eines Hochfrequenzresonanzkreises mit Vierfachkondensator hat gegenüber der ersten Ausführungsform gemäß den Fig. 1 bis 3 den Vorteil, daß die beiden Kapazitäten C1, C2 und C3, C4 bei einer gegebenen Frequenz durch die Reihenschaltung größer bemessen sind als die Kapazitäten C1 und C2 nach Fig. 4. Dadurch wirken sich äußere parasitäre Kapazitäten weniger auf die Resonanzfrequenz aus.

Die erfindungsgemäßen Resonanzkreise lassen sich vorzugsweise im UHF-Bereich zwischen 400 ... 500 MHz anwenden, wobei ein Resonanzwiderstand von 15 ... 20 Ohm durchaus realisierbar ist. Bei einem Volumen des Hochfrequenzresonanzkreises von nur 1 cm³ lassen sich Güten von 250 und mehr erreichen. Der Hochfrequenzresonanzkreis weist leicht zugängliche Anschlüsse 37, 39, 48, 49 auf, wodurch mittels von außen angeschlossener Zusatzkapazitäten in Form von Trimmerkondensatoren oder Kapazitätsdioden eine gewisse Veränderung der Resonanzfrequenz des Kreises möglich ist.

Die Doppel-Plattenkondensatoren 43, 44 können gleiche oder gegebenenfalls auch verschiedene Kapazitätswerte aufweisen. Der Aufbau der Doppel-Plattenkondensatoren kann auch derart gewählt werden, daß Teilkondensatoren mit Anzapfungen entstehen, indem zum Beispiel bei einem Doppel-Plattenkondensator durch ein weiteres Plättchen mit Kondensatorbelägen ein Reihenkondensator mit dem Kapazitätswert C2' entsteht; vgl. gestrichelt gezeichneter Kondensator in Fig. 4.

Auf das Bodenteil 11 (Fig. 1) und die Öffnung 31 der Leiterplatte 32 kann gegebenenfalls verzichtet werden, wenn – wie in Fig. 8 gezeigt – eine entsprechend große, als Abschirmung dienende Leiterfläche 60 an der Unterseite einer Leiterplatte 61 vorgesehen ist. Um die Leiterfläche 60 mit einer Abschirmkappe 62 leitend zu verbinden, ist erstens auf der Oberseite der Leiterplatte eine ringförmige Leiterbahn 63 vorhanden, die über mehrere durchkontaktierte Löcher 64 mit der Leiterfläche 60 in Verbindung steht. Zweitens trägt die Abschirmkappe an dem offenen Ende Lappen 65, die durch Öffnungen 66 der Leiterplatte ragen und mit der Leiterfläche 60 elektrisch verbunden, zum Beispiel verlötet, sind.

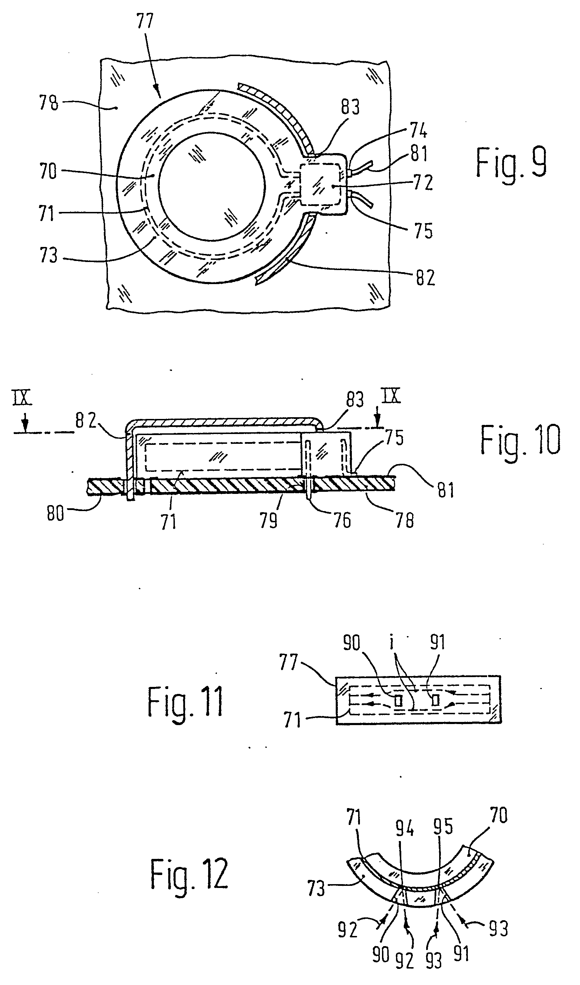

Gemäß einer dritten Ausführungsform des erfindungsgemäßen Resonazkreises (Fig. 9) sind eine Isolierstoffrolle 70, eine bandförmige Spule 71 und ein Kondensator 72, der vorzugsweise ein Vierfachkondensator wie in Fig. 5 und 6 ist, von einer Schicht 73 aus einem hochisolierenden und hochfrequenzdämpfungsarmen Kunststoff umgeben. Die Anschlüsse des Kondensators 72 sind als Lappen 74, 75 ausgebildet, die an der Unterseite des Kondensators aus diesem seitlich herausragen. Den Massenanschluß bildet beispielsweise ein Anschlußstift 76, der aus der Unterseite des Kondensators herausragt. Auf diese Weise entsteht eine abgeschlossene Spulen-Kondensator-Baueinheit 77.

Die Baueinheit wird auf eine Leiterplatte 78 gesteckt, wobei der Anschlußstift 76 durch eine entsprechende Öffnung 79 der Leiterplatte ragt und mit einer Abschirmfläche 80 leitend verbunden wird.

Die Lappen 74, 75 werden mit entsprechenden Leiterbahnen 81 auf der Oberseite der Leiterplatte verbunden.

Eine Abschirmkappe 82, die mit einem radialen Schlitz 83 für den Kondensator 72 versehen ist, ist in gleicher Weise wie die Abschirmkappe 62 in Fig. 8 auf der Leiterplatte angeordnet.

Um die Möglichkeit zu haben, die Induktivität der Spule 71 der Spulen-Kondensator-Baueinheit 77 (Fig. 10) nachträglich, das heißt nach dem Aufbringen der Schicht 73, abzugleichen, enthält diese auf der dem Kondensator 72 gegenüberliegenden Seite der Spule zwei schlitzförmige, axiale und einen gewissen Abstand voneinander aufweisende Öffnungen 90 und 91, die eine kleinere Höhe als die Spule aufweisen. Die Öffnungen sind nach außen erweitert, um ein gezieltes Ausbrennen von Teilen der Spule mittels Laserstrahlen 92, 93 zu gestatten. Es entstehen dadurch in der bandförmigen Spule Schlitze 94 und 95, so daß die Strombahnen i im Bereich der Schlitze eingeengt werden, wodurch eine Änderung der Induktivität der Spule bewirkt wird.

Die Spule 14 kann beispielsweise auf eine aus Keramikmaterial bestehende Isolierstoffrolle aufgedampft und an ihren Enden mit einem bandförmigen Leiter versehen sein. Dabei kann das Keramikmaterial so gewählt sein, daß temperaturbedingte Änderungen der Kapazitätswerte des Plattenkondenators bzw. des Doppelkondensators durch gegenläufige temperaturbedingte Änderungen der Induktivität der Spule kompensiert werden. Damit wird eine Temperaturkompensation des gesamten Resonanzkreises erreicht.

Der Hochfrequenzresonanzkreis läßt sich im übrigen nicht nur in Oszillatoren, sondern auch mit Vorteil bei Filtern anwenden.

**Patentansprüche**

1. Hochfrequenzresonanzkreis hoher Güte und kleinen Resonanzwiderstandes aus einer Spule und einem Kondensator, die in einem Abschirmtopf untergebracht sind, dadurch gekennzeichnet, daß ein Ende (15) der in einem zylindrischen Abschirmtopf (12) koaxial angeordneten Spule (14) mit den innenliegenden Kondensatorbelägen (23, 24) eines in einem radialen Schlitz (17) des Abschirmtopfes enthaltenen Doppel-Plattenkondensators (18) leitend verbunden ist und daß das andere Ende (16) der Spule mit dem auf dem Massepotential liegenden Abschirmtopf und den außenliegenden Kondensatorbelägen (22, 25) des Doppel-Plattenkondensators verbunden ist.

2. Hochfrequenzresonanzkreis nach Anspruch 1, dadurch gekennzeichnet, daß die Spule (14) aus einem elektrisch gut leitenden Band besteht.

3. Hochfrequenzresonanzkreis nach Anspruch 2, dadurch gekennzeichnet, daß das Band ein versilbertes Kupferband oder Reinsilberband ist.

4. Hochfrequenzresonanzkreis nach Anspruch 2 oder 3, dadurch gekennzeichnet, daß das Band auf einer Isolierstoffrolle (13) angeordnet ist.

5. Hochfrequenzresonanzkreis nach Anspruch 1 oder einem der folgenden, dadurch gekennzeichnet, daß jeder Doppel-Plattenkondensator (18) ein hochisolierendes Plättchen (20) mit beidseitig vorhandenen Kondensatorbelägen (22, 23) aufweist, daß das eine Ende (15) der Spule (14) zwischen den einander zugekehrten Kondensatorbelägen (23, 24) des Doppel-Plattenkondensators (18) hindurch nach außen geführt ist und daß die beiden außenliegenden Kondensatorbeläge (22, 25) von einer Klammer (19) aus elektrisch leitendem Material umschlossen sind.

6. Hochfrequenzresonanzkreis nach Anspruch 5, dadurch gekennzeichnet, daß zwei Doppel-Plattenkondensatoren (43, 44) durch eine weitere Klammer (45) zu einem Vierfach-Plattenkondensator (42) zusammengefaßt sind und daß die Enden (15, 16) der Spule (14) zwischen je zwei unmittelbar benachbarten Kondensatorbelägen (23, 24) hindurch nach außen geführt sind.

7. Hochfrequenzresonanzkreis nach Anspruch 1 oder einem der folgenden, dadurch gekennzeichnet, daß der Doppel- bzw. Vierfach-Plattenkondensator (18, 42) teilweise aus dem radialen Schlitz (17, 83) des Abschirmtopfes herausragt.

8. Hochfrequenzresonanzkreis nach Anspruch 1, dadurch gekennzeichnet, daß der Abschirmtopf (12) aus einem Oberteil (10) und einem leitend damit verbundenen Bodenteil (11) besteht.

9. Hochfrequenzresonanzkreis nach Anspruch 1, 4 oder 8, dadurch gekennzeichnet, daß die Spule (14) und die Isolierstoffrolle (13) in dem Oberteil (10) des Abschirmtopfes (12) angeordnet sind.

10. Hochfrequenzresonanzkreis nach Anspruch 8, dadurch gekennzeichnet, daß das Bodenteil (11) in eine Öffnung (31) einer Leiterplatte (32) paßt und daß das Bodenteil mit einem ringförmigen Flansch (30) versehen ist, der sich an der Oberseite der Leiterplatte abstützt, und daß die Unterseite (33) des Bodenteils in der Ebene der Leiterplattenunterseite bzw. der Leitungsbahnen (34, 35) liegt.

11. Hochfrequenzresonanzkreis nach Anspruch 1 oder einem der folgenden, dadurch gekennzeichnet, daß der Abschirmtopf aus einem Oberteil (62) und einer Leiterfläche (60) besteht, die an der Unterseite einer das Oberteil tragenden Leiterplatte (61) vorhanden ist und mit dem Oberteil elektrisch leitend verbunden ist.

12. Hochfrequenzresonanzkreis nach Anspruch 1 oder einem der folgenden, dadurch gekennzeichnet, daß Spule (71), Isolierstoffrolle (70), Plattenkondensator (72) und Anschlußelemente (74 ... 76) gemeinsam in eine Schicht (73) aus hochisolierendem, hochfrequenzdämpfungsarmem Kunststoff eingebettet und dadurch zu einer Spulen-Kondensator-Baueinheit (77) zusammengefaßt sind.

13. Hochfrequenzresonanzkreis nach Anspruch 12, dadurch gekennzeichnet, daß der Kunststoff ein Polycarbonat, Polystyrol oder ein Polyfluoräthylen ist.

14. Hochfrequenzresonanzkreis nach Anspruch 12 oder 13, dadurch gekennzeichnet, daß die Anschlüsse des Plattenkondensators (72) seitlich an der Unterseite des Kondensators vorstehende Lappen (74, 75) sind, die mit Leitungsbahnen (81) einer Leiterplatte (78) verbindbar sind.

15. Hochfrequenzresonanzkreis nach Anspruch 12 oder 13, dadurch gekennzeichnet, daß ein Abgleich der Induktivität der Spule (71) durch Einbrennen zweier, einen gewissen Abstand voneinander aufweisender Schlitze (94, 95) erfolgt.

16. Hochfrequenzresonanzkreis nach Anspruch 15, dadurch gekennzeichnet, daß die Schicht (73) in dem genannten Abstand zwei Öffnungen (90, 91) zum Durchtritt von Laserstrahlen enthält.

## Claims

1. A high-frequency resonating circuit having high Q and a low resonance resistance, comprising a coil and a capacitor, which are disposed in a screen box, characterised in that one end (15) of the coil (14), which is disposed coaxially in a cylindrical screen box (12), is conductively connected to the inner plates (23, 24) of a double-plate capacitor (18) contained in a radial slot (17) in the screen box, and the other end (16) of the coil is connected to the screen box, which is connected to earth potential, and the outer plates (22, 25) of the double-plate capacitor.

2. A high-frequency resonating circuit as claimed in claim 1, characterised in that the coil (14) comprises a strip having good electrical conductivity.

3. A high-frequency resonating circuit as claimed in claim 2, characterised in that the strip is a silvered copper strip or a pure silver strip.

4. A high-frequency resonating circuit as claimed in claim 2 or 3, characterised in that the strip is disposed on a roll (13) made from insulating material.

5. A high-frequency resonating circuit as claimed in claim 1 or any fo the subsequent claims, characterised in that each double-plate capacitor (18) has a highly-insulating plate (20) with capacitor plates (22, 23) on both sides, one end (15) of the coil (14) is guided to the outside between the capacitor plates (23, 24), which face each other, of the double-plate capacitor (18), and the two outer capacitor plates (22, 25) are surrounded by a clip (19) made from an electrically conductive material.

6. A high-frequency resonating circuit as claimed in claim 5, characterised in that two double-plate capacitors (43, 44) are combined by a further clip (45) to form a quadruple-plate capacitor (42), and the ends (15, 16) of the coil (14) are guided towards the outside between two directly adjacent capacitor plates (23, 24).

7. A high-frequency resonating circuit as claimed in claim 1 or any of the subsequent claims, characterised in that the double- or quadruple-plate capacitor (18, 42) projects in part out of the radial slot (17, 83) in the screen box.

8. A high-frequency resonating circuit as claimed in claim 1, characterised in that the screen box (12) comprises an upper part (10) and a base part (11), which is conductively connected thereto.

9. A high-frequency resonating circuit as claimed in claim 1, 4 or 8, characterised in that the coil (14) and the roll (13) made from insulating material are disposed in the upper part (10) of the screen box (12).

10. A high-frequency resonating circuit as claimed in claim 8, characterised in that the base part (11) fits into an opening (31) in a printed circuit board (32) and the base part is provided with an annular flange (30), which rests on the upper side of the printed circuit board, and the underside (33) of the base part lies in the plane of the underside of the printed circuit board or the conductor paths (34, 35).

11. A high-frequency resonating circuit as claimed in claim 1 or any of the subsequent claims, characterised in that the screen box comprises an upper part (62) and a conductor surface (60), which is provided on the underside of a printed circuit board (61) carrying the upper part and is connected to the upper part in an electrically conductive manner.

12. A high-frequency resonating circuit as claimed in claim 1 or any of the subsequent claims, characterised in that the coil (71), roll (70) made from insulating material, plate capacitor (72) and connecting elements (74 ... 76) are embedded together in a layer (73) of highly insulating plastic material which has a low capacity to damp high frequencies and, as a result, are combined to form a coil/capacitor unit (77).

13. A high-frequency resonating circuit as claimed in claim 12, characterised in that the plastic material is a polycarbonate, polystyrene or polyfluoroethylene.

14. A high-frequency resonating circuit as claimed in claim 12 or 13, characterised in that the connections of the plate capacitor (72) are lugs (74, 75) which project laterally on the underside of the capacitor and which can be connected to conductor paths (81) of a printed circuit board (78).

15. A high-frequency resonating circuit as claimed in claim 12 or 13, characterised in that the inductance of the coil (71) is adjusted by burning in two slots (94, 95) at a particular distance from one another.

16. A high-frequency resonating circuit as claimed in claim 15, characterised in that, in the above-mentioned space between the slots, the layer (73) contains two holes (90, 91) to allow laser beams to pass through.

## Revendications

1. Circuit de résonance à haute fréquence de facteur élevé et de faible résistance de résonance, se composant d'une bobine et d'un condensateur, logés dans une boîte de blindage, caractérisé en ce qu'une extrémité (15) de la bobine (14) disposée coaxialement dans une boîte de blindage (12) cylindrique est reliée de manière électriquement conductrice aux revêtements de condensateur (23, 24) intérieurs d'un double condensateur à lames (18) contenu dans une fente radiale (17) de la boîte de blindage, et en ce que l'autre extrémité (16) de la bobine est reliée à la boîte de blindage placée au potentiel de masse et aux revêtements de condensateur (22, 25) extérieurs du double condensateur à lames.

2. Circuit de résonance à haute fréquence selon la revendication 1, caractérisé en ce que la bobine (14) se compose d'un ruban bon conducteur électrique.

3. Circuit de résonance à haute fréquence selon la revendication 1, caractérisé en ce que le ruban est un ruban de cuivre argenté ou un ruban d'argent pur.

4. Circuit de résonance à haute fréquence selon la revendication 1, caractérisé en ce que le ruban est disposé sur un rouleau de matière isolante (13).

5. Circuit de résonance à haute fréquence selon la revendication 1 ou l'une des revendications suivantes, caractérisé en ce que chaque double condensateur à lames (18) présente une plaquette (20) hautement isolante avec des revêtements de condensateur (22, 23) sur les deux côtés, en ce qu'une extrémité (15) de la bobine (14) est passée vers l'extérieur, entre les revêtements de condensateur (23, 24) du double condensateur (18) tournés l'un vers l'autre, et en ce que les deux revêtements de condensateur (22, 25) extérieurs sont entourés d'une pince (19) en matériau électriquement conducteur.

6. Circuit de résonance à haute fréquence selon la revendication 5, caractérisé en ce que deux doubles condensateur à lames (43, 44) sont assemblés au moyen d'une pince (45) supplémentaires en formant un quadruple condensateur à lames (42) et que les extrémités (15, 16) de la bobine (14) sont passées à l'extérieur, entre deux revêtements de condensateur (23, 24) immédiatement voisins.

7. Circuit de résonance à haute fréquence selon la revendication 1, ou l'une des revendications suivantes, caractérisé en ce que le double, ou quadruple condensateur (18, 42) émerge partiellement hors de la fente radiale (17, 83) de la boîte de blindage.

8. Circuit de résonance à haute fréquence selon la revendication 1, caractérisé en ce que la boîte de blindage (12) se compose d'une partie supérieur (10) et d'une partie de fond (11) étant reliée de manière électriquement conductrice.

9. Circuit de résonance à haute fréquence selon la revendication 1, 4 ou 8, caractérisé en ce que la bobine (14) et le rouleau de matière isolante (13) sont disposés dans la partie supérieure (10) de la boîte de blindage (12).

10. Circuit de résonance à haute fréquence selon la revendication 8, caractérisé en ce que la partie de fond (11) est ajustée dans une ouverture (31) d'une plaque conductrice (32) et en ce que la partie de fond est pourvue d'une bride de forme annulaire (30) s'appuyant sur le côté supérieur de la plaque conductrice, et en ce que le côté inférieur (33) de la partie de fond est situé dans le plan du côté inférieur de la plaque conductrice, ou des pistes conductrices (34, 35).

11. Circuit de résonance à haute fréquence selon la revendication 1, ou l'une des revendications suivantes, caractérisé en ce que la boîte de blindage se compose d'une partie supérieur (62) et d'une face conductrice (60), existant sur le côté inférieur d'une plaque conductrice (61) portant la partie supérieure er reliée de manière électriquement conductrice à la partie supérieure.

12. Circuit de résonance à haute fréquence selon la revendication 1, ou l'une des revendications suivantes, caractérisé en ce que la bobine (71), le rouleau de matière isolante (70), le condensateur à lames (72) et les éléments de raccordement (74 à 76) sont encastrés en commun dans une couche (76) de matière plastique hautement isolante, à faible amortissement des hautes fréquences, et assemblées de ce fait en une unité structurelle (77) bobine-condensateur.

13. Circuit de résonance à haute fréquence selon la revendication 2, caractérisé en ce que la matière plastique est une polycarbonate, un polystyrène ou un polyfluoréthylène.

14. Circuit de résonance à haute fréquence selon la revendication 12 ou 13, caractérisé en ce que les raccordements du condensateur à lames (72) sont des pattes (74, 75) situées latéralement en saillie sur le côté inférieur du condensateur, susceptibles d'être reliées aux pistes conductrice (81) d'une plaque conductrice (78).

15. Circuit de résonance à haute fréquence selon la revendication 12 ou 13, caractérisé en ce qu'un réglage de l'inductance de la bobine (71) s'effectue par découpe par brûlage de deux fentes (94, 95) présentant un certain écartement réciproque.

16. Circuit de résonance à haute fréquence selon la revendication 15, caractérisé en ce que la couche (15) contient dans l'intervalle indiqué deux ouvertures (90, 91) destinées au passage de rayons laser.

Fig.1

Fig.2

Fig.3

Fig.4

Fig.5

Fig.6

Fig.7

Fig.8

Fig. 9

Fig. 10

Fig. 11

Fig. 12